(19) Europäisches Patentamt / European Patent Office / Office européen des brevets

(11) **EP 2 506 426 A1**

(12) **EUROPEAN PATENT APPLICATION**

(43) Date of publication:
**03.10.2012 Bulletin 2012/40**

(51) Int Cl.:
*H03F 3/217* (2006.01)   *H03F 3/193* (2006.01)
*H03F 3/21* (2006.01)   *H03F 3/24* (2006.01)
*H03M 3/00* (2006.01)   *H04L 27/12* (2006.01)
*H04B 1/04* (2006.01)   *H04L 25/49* (2006.01)
*H04L 27/36* (2006.01)

(21) Application number: **11305362.3**

(22) Date of filing: **31.03.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Alcatel Lucent**
**75007 Paris (FR)**

(72) Inventor: **Haslach, Christoph**
**70178, Stuttgart (DE)**

(74) Representative: **Kleinbub, Oliver**
**Alcatel Lucent**
**Intellectual Property & Standards**
**Lorenzstrasse 10**
**70435 Stuttgart (DE)**

(54) **A method for amplification of a signal, and an amplifying device therefor**

(57) The invention concerns a method for amplification of a signal (SA) using a processing means (PM) with at least two modulators (MOD1-MODN) , and using at least one switching power amplifier (SPA1-SPAN) , wherein the signal (SA) is processed in said processing means (PM) resulting in modulated input signals (SD1-SDN) for said at least one switching power amplifier (SPA1-SPAN) , said modulated input signals (SD1-SDN) are generated in such a way, that they have a higher correlation for the in-band part of the spectrum than for the out-of-band part of the spectrum, said modulated input signals (SD1-SDN) are amplified in the at least one switching power amplifier (SPA1-SPAN) resulting in output signals, and said output signals are combined resulting in an amplified copy of the signal, and an amplifying device therefor.

Fig. 5

**Description**

**Field of the invention**

The invention relates to a method for amplification of a signal using a processing means with at least one modulator, and using at least one switching power amplifier, and an amplifying device adapted to perform said method.

**Background**

In order to support highly efficient switching power amplifiers, signals with continuous amplitude, or multi-level signals, need to be converted to 2-level signals. In general, this transformation is executed by so-called delta sigma modulators (DSM), also called sigma delta modulators, or pulse length modulators (PLM), also called pulse width modulators.

These delta sigma modulators (DSM) or pulse length modulators (PLM) are promising modulator concepts e.g. for highly efficient class-S power amplifiers, i.e. switching power amplifiers, used for the amplification of radio signals to be transmitted over an air interface in a communication network. In principle, they allow for an ideal conversion of signals with continuous amplitude and limited bandwidth to a time continuous 2-level signal. This 2-level signal is suited for switching amplifier stages. The 2-level signal can be reconverted to the continuous amplitude signal e.g. simply by a reconstruction filter after the amplification stage.

Further applications of class-S power amplifiers comprise the supply of electrical power for other devices such as in speed control of electric motors, the use of class-S power amplifiers as audio switching amplifiers, or the use of class-S power amplifiers as brightness control of light sources.

**Summary**

Class-S is a very promising technique for future mobile and wireless applications and networks that promises highly energy efficient power amplification of radio signals. Nevertheless, nowadays implementations of class-s amplifiers still suffer from imperfections of the employed components which results in deteriorated energy efficiency. A key aspect in this context is the termination of the filter impedance to the signal spectrum and to the switching power amplifier. If this termination is not perfect, power will be dissipated in the combination of reconstruction filter and switching power amplifier. This power dissipation is connected with the out-of-band spectral components of the input signal of the switching power amplifier. These out-of-band spectral components are generated in the class-S modulator, which can e.g. be a delta sigma modulator (DSM) or a pulse length modulator (PLM), and will be referred to as quantization noise in the following.

A key parameter in this context is the so-called coding efficiency which describes the ratio between in-band power to total power of the signal after the class-S modulator. The coding efficiency should be as high as possible in order to have a high energy efficiency.

The object of the invention is thus to propose a method for amplification of a signal using switching power amplifiers with an increased energy efficiency.

According to the state of the art, a single class-S modulator either feeds a single switching power amplifier, or several switching power amplifiers which are used in parallel. In general, the coding efficiency of such arrangements is relatively low, as merely using several switching power amplifiers in parallel does not improve the coding efficiency.

The basic idea of the invention is to feed at least one switching power amplifier with at least two switching signals that comprise highly correlated in-band signals and only weakly correlated or even uncorrelated out-of-band signals, i.e. quantization noise, and to combine the signals of the at least one switching power amplifier after amplification. The use of weakly correlated or even uncorrelated out-of-band signals of the switching signals reduces the out-of-band power as will be described in the following. Different architectures for the combining of the signals after amplification, and also different methods on how to generate the set of switching signals for the parallel switching power amplifiers are proposed.

In an embodiment of the invention, the signal to be amplified is split resulting in at least two identical signals, each of said at least two identical signals is modulated in a dedicated modulator for each of said at least one parallel switching power amplifier resulting in modulated input signals, and at least two different architectures are used for said dedicated modulators. By means of using different architectures for said dedicated modulators, highly correlated in-band signals and only weakly correlated or even uncorrelated out-of-band signals are generated.

In a further embodiment of the invention, the signal to be amplified is split resulting in at least two identical signals, said at least two identical signals are differently modified resulting in at least two modified signals, and each of said at least two modified signals is modulated in a dedicated modulator resulting in modulated input signals.

Further features and advantages are stated in the following description of exemplary embodiments, with reference to the figures, which shows significant details, and are defined by the claims. The individual features can be implemented individually by themselves, or several of them can be implemented in any desired combination.

In the following the invention will be explained further making reference to the attached figures.

Fig. 1 schematically shows an amplifying device with a delta sigma modulator, a switching power amplifier and a filter according to the state-of-the-art.

Fig. 2 schematically shows a switching power amplifier architecture relying on a voltage switched circuit topology according to the state-of-the-art.

Fig. 3 schematically shows a delta sigma modulator according to the state-of-the-art.

Fig. 4 schematically shows an amplifying device with a processing means and parallel switching power amplifiers according to an embodiment of the invention.

Fig. 5 schematically shows an amplifying device with two parallel switching power amplifiers, with a dedicated modulator for each of the two parallel switching power amplifiers, and a combiner for combining amplified and filtered output signals according to an embodiment of the invention.

Fig. 6 schematically shows an amplifying device with N parallel switching power amplifiers, with a dedicated modulator for each of the N parallel switching power amplifiers, and a dedicated antenna for each of the N amplified and filtered output signals for air combining according to an embodiment of the invention.

Fig. 7 schematically shows an amplifying device with two parallel switching power amplifiers, with a dedicated modulator for each of the two parallel switching power amplifiers, and a combiner for combining amplified output signals before filtering according to an embodiment of the invention.

Fig. 8 schematically shows a structure of a bandpass delta sigma modulator that can be used for implementing the invention.

Fig. 9 schematically shows initial states that can be used for a bandpass delta sigma modulator according to an embodiment of the invention.

Fig. 10 schematically shows simulation results for the power spectral density of an amplifying device using the signal of a single delta sigma modulator compared to an amplifying device using signals of 4 appropriately initialized delta sigma modulators according to an embodiment of the invention.

Fig. 11 schematically shows the zoomed representation of the simulation results depicted in fig. 10.

Fig. 12 schematically shows an amplifying device with two parallel switching power amplifiers, with a dedicated modulator for each of the two parallel switching power amplifiers, and a modifying device for dedicated modification of input signals before modulation according to an embodiment of the invention.

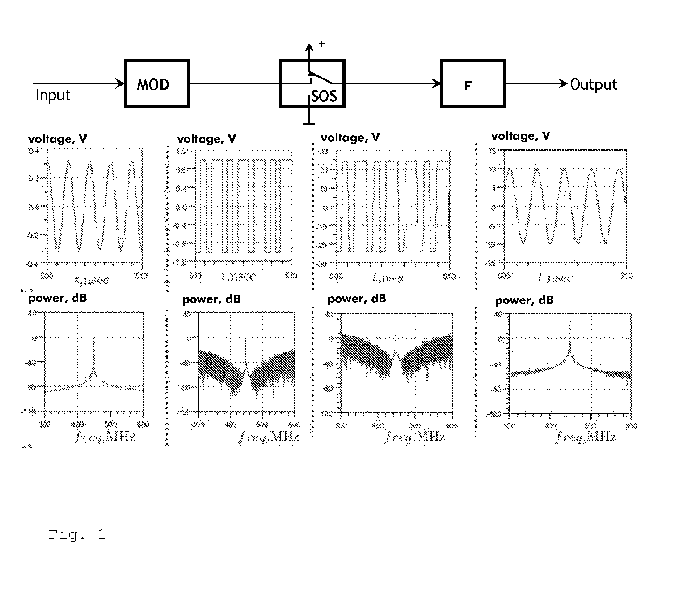

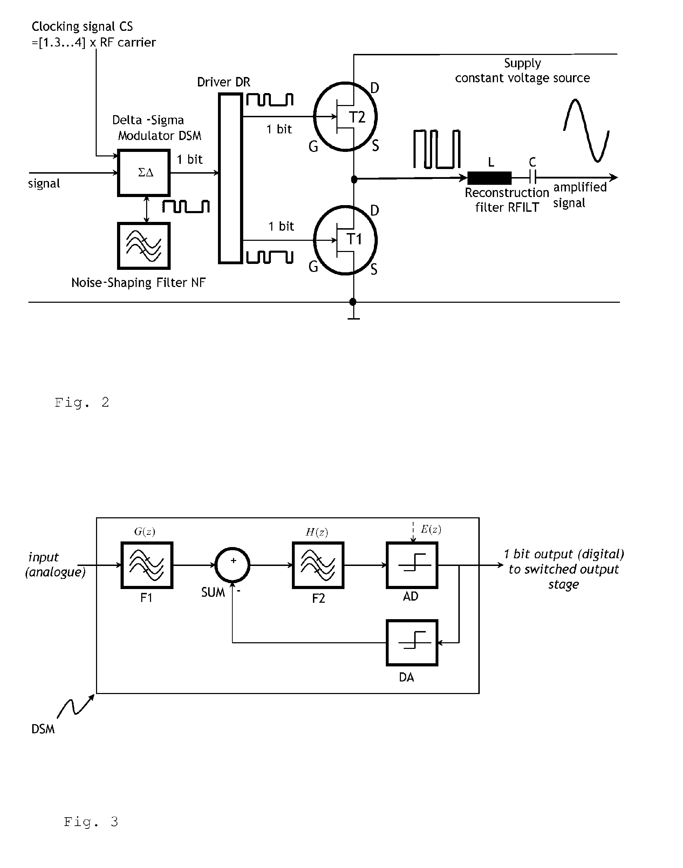

The principle structure of an amplifying device for signal amplification comprising a modulator MOD, a switching power amplifier SPA, and a filter RFILT is depicted in the upper row in fig. 1. The switching power amplifier SPA comprises e.g. a driver and transistors as depicted in more detail in fig. 2. The modulator MOD can be e.g. a delta sigma modulator as depicted in more detail in fig. 3.

The modulator MOD has an input for receiving input signals. The output of the modulator MOD is connected to the input of the switching power amplifier SPA.

The output of the switching power amplifier SPA is connected to the input of the filter RFILT, and the filter RFILT comprises an output for transmitting output signals.

In the middle row, 4 diagrams are showing the signal voltage in volts versus time in nanoseconds from left to right for signals at the input of the modulator MOD, at the output of the modulator MOD, at the output of the switching power amplifier SPA, and at the output of the filter RFILT.

In the lower row, 4 diagrams are showing the signal power density spectrum in dBm versus frequency in GHz from left to right for signals at the input of the modulator MOD, at the output of the modulator MOD, at the output of the switching power amplifier SPA, and at the output of the filter RFILT.

As can be seen from the first two diagrams in the middle row, the modulator MOD converts analogue signals into digital 2-level signals, and said digital 2-level signals will be transmitted to the switching power amplifier SPA.

In the third diagram in the middle row, the amplified digital 2-level signal at the output of the switching power amplifier SPA is shown. In order to convert the amplified digital 2-level signals into amplified analogue signals, the filter RFILT is e.g. a reconstruction filter preferably of low pass or band pass type for converting digital signals into analogue signals. The amplified analogue signal is shown in the last diagram in the middle row.

In the following, the basic principle of an amplifying device using a delta sigma modulator and a switching power amplifier is described, and subsequently the application of switching power amplifiers with delta sigma modulators or pulse width modulators is depicted for several embodiments of the invention.

As an example for such an amplifying device, a voltage switched power amplifier system according to the state-of-the-art is shown in fig. 2. Such a voltage switched power amplifier system comprises a delta sigma modulator DSM with inputs for reception of an analogue radio frequency input signal, and for reception of a clocking signal CS. An output of the delta sigma modulator DSM is connected to an input of a driver DR.

Preferably, the delta sigma modulator DSM is connected to a noise-shaping filter NF or comprises a noise shaping filter.

A first output of the driver DR is connected to the gate G of a first transistor T1, and a second output of the driver DR is connected to the gate G of a second transistor T2.

The source S of the first transistor T1 is connected to ground, and the source of the second transistor T2 is connected to the drain of the first transistor T1.

The drain of the first transistor T1 and the source of the second transistor T2 are connected to an output for amplified radio frequency signals, via a reconstruction filter RFILT that comprises an inductor L and a capacitor C in series. There are variants of the L-C filter topology which however are of no importance for the invention as disclosed.

The drain of the second transistor T2 is connected to the supply of a constant voltage source.

In a method for signal amplification using a voltage switched power amplifier system according to the state-of-the-art as shown in fig. 2, analogue radio frequency input signals, are sent to the delta sigma modulator DSM. Furthermore, clocking signals with a multiple of the radio frequency carrier frequency are sent to the delta sigma modulator DSM.

In the delta sigma modulator DSM, the analogue radio frequency input signals, are converted into digital 1-bit or higher resolution signals. The sampling rate is determined by the received clocking signals. The digital 1-bit signals are provided at the output of the delta sigma modulator DSM.

Preferably, the noise shaping filter NF is used to minimize quantization error by means of shifting quantization noise into frequency ranges that are less or not relevant for signal processing.

Said digital 1-bit signals are sent to the driver DR that generates first driver signals based on the digital 1-bit signals and second driver signals based on the inverted digital 1-bit signals. The first driver signals are sent to the gate of the second transistor T2, and the second driver signals are sent to the gate of the first transistor T1. The output signals of the driver DR are thus in antiphase which means if the first transistor T1 is on, the second transistor T2 is off and vice versa. The described amplifier architecture with two transistors T1, T2 is just an example, and in alternative architectures, only one, as e.g. in Class J amplifiers, or more than two transistors are used, which has however no influence on the invention. In the latter case, such alternative architectures are e.g. multibit architectures, using two transistors more per each bit more.

The capacitor C and the inductor L together build a reconstruction filter RFILT used to generate smooth analogue output signals that are provided at the output for amplified radio frequency signals.

Fig. 3 is illustrating a delta sigma modulator DSM according to the state-of-the-art. The delta sigma modulator DSM comprises a filter F1, a summer SUM, a noise shaping filter F2, an analog-to-digital converter AD and a digital-to-analog converter DA.

The filter F1 has an input for receiving analogue input signals. The output of the filter F1 is connected to a first input of the summer SUM.

The output of the summer SUM is connected to the input of the noise shaping filter F2, and the output of the noise shaping filter F2 is connected to the input of the analog-to-digital converter AD.

The output of the analog-to-digital converter AD is on the one hand connected to the input of the digital-to-analog converter DA, and can on the other hand be connected to an external device, as e.g. the driver DR of the switching power amplifier in fig. 2, for transmitting digital output signals.

The output of the digital-to-analog converter DA is connected to a second inverting input of the summer SUM.

In principle, an analogue radio frequency input signal is encoded in the delta sigma modulator DSM into a two level digital output sequence that is appropriate for driving a switched output stage of a switching power amplifier.

As already mentioned above, in order to increase the coding efficiency, the basic idea of the invention is to feed at least one switching power amplifier with switching signals that comprise highly correlated in-band signals and only weakly correlated or even uncorrelated out-of-band signals, i.e. quantization noise, and to combine the signals of the at least two switching power amplifiers after amplification.

For the case of combination of two amplified signals $x(t)$ and $y(t)$, the power spectral density $|S(f)|^2$ of the

combined amplified signal *s(t)=x(t)+y(t)* results from Fourier transformation of the autocorrelation function.

As a result, the power spectral density $|S(f)|^2$ is calculated in the following way:

$$\left|S(f)\right|^2 = \left|X(f)\right|^2 + \left|Y(f)\right|^2 + X^*(f)Y(f) + Y^*(f)X(f)$$

The use of weakly correlated or even uncorrelated out-of-band parts of the switching signals with frequencies $f < -f_b$ or $f > f_b$ reduces the out-of-band power, as the cross-correlation terms $X^*(f)Y(f)$ and $Y^*(f)X(f)$ are reduced.

However, the correlation of the in-band parts of the switching signals with *frequencies* — $f_b \leq f \leq f_b$ shall be high which results in a significant contribution of the cross-correlation terms $X^*(f)Y(f)$ and $Y^*(f)X(f)$ to the in-band power.

Thus, the coding efficiency can be increased by adding or combining switching signals that comprise highly correlated in-band signals and only weakly correlated or even uncorrelated out-of-band signals.

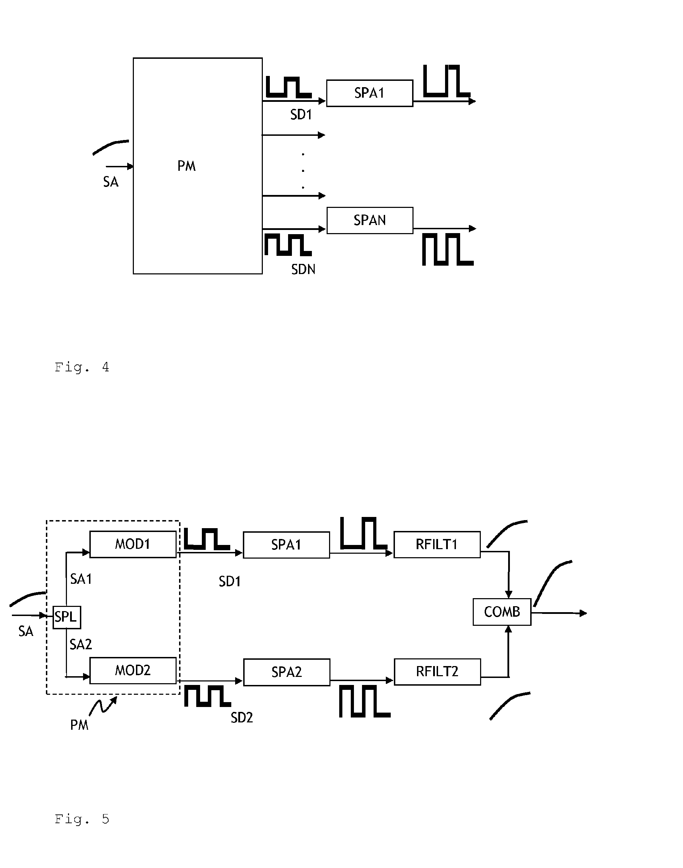

Fig. 4 schematically shows an amplifying device comprising a processing means PM and N parallel switching power amplifiers SPA1-SPAN according to an embodiment of the invention.

The processing means PM has an input for receiving input signals, and N outputs, each of said N outputs being connected to an input of one of the N parallel switching power amplifiers SPA1-SPAN.

Each of said N parallel switching power amplifiers SPA1-SPAN has an output for transmitting amplified output signals for further processing and combining, which is not shown in fig. 4, but will be described in more detail in embodiments below.

In a method for amplification of a signal using the amplifying device depicted in fig. 4, an analogue input signal SA is sent to the input of the processing means PM. The processing means PM comprises at least one modulator for generation of modulated input signals SD1-SDN for said N parallel switching power amplifiers SPA1-SPAN. The modulated input signals SD1-SDN are generated in such a way, that they have a higher correlation for the in-band part of the spectrum than for the out-of-band part of the spectrum.

The modulated input signals SD1-SDN are amplified in the at least two parallel switching power amplifiers SPA1-SPAN resulting in output signals. Said output signals are combined resulting in an amplified copy of the signal, which is not shown in fig. 4. Due to the use of modulated input signals SD1-SDN that comprise highly correlated in-band signals and only weakly correlated or even uncorrelated out-of-band signals, the coding efficiency is increased compared to amplifying devices according to the state-of-the-art, as e.g. depicted in fig. 1.

Fig. 5 schematically shows an amplifying device with a splitter SPL, a first and a second modulator MOD1, MOD2, a first and a second parallel switching power amplifier SPA1, SPA2, a first and a second filter RFILT1, RFILT2, and a signal combining device COMB for combining amplified and filtered output signals according to an embodiment of the invention.

The splitter SPL has an input for receiving input signals, and a first and a second output, the first output being connected to an input of the first modulator MOD1, and the second output being connected to an input of the second modulator MOD2. The first modulator MOD1 has an output which is connected to an input of the first parallel switching power amplifier SPA1, and the second modulator MOD2 has an output which is connected to an input of the second parallel switching power amplifier SPA2.

The first parallel switching power amplifier SPA1 has an output which is connected to an input of the first filter RFILT1, and the second parallel switching power amplifier SPA2 has an output which is connected to an input of the second filter RFILT2. The output of the first filter RFILT1 is connected to a first input of the signal combining device COMB, and the output of the second filter RFILT2 is connected to a second input of the signal combining device COMB. The signal combining device COMB has an output for the transmission of amplified analogue signals.

In a method for signal amplification using an amplifying device according to the invention as shown in fig. 5, an analogue input signal SA is sent to the input of the splitter SPL. In the splitter SPL, the analogue input signal SA is split in two identical or nearly identical analogue signals SA1, SA2 which are sent to the input of the first and second modulator MOD1, MOD2 respectively.

According to a first embodiment of the invention, the first and the second modulator MOD1, MOD2 have a different architecture. Different architecture means in this context, that the modulators MOD1, MOD2 are designed for identical or similar carrier frequencies but they incorporate different noise shaping filters. This means that they differ in the values of their filter coefficients and/or in the order of the employed noise shaping filters.

A first and a second modulated digital switching signal SD1, SD2 is generated from the same or nearly same analogue signal SA1, SA2 in the first and the second modulator MOD1, MOD2 respectively. Due to the different architecture of the first and the second modulator MOD1, MOD2, the in-band components of the signals are identical, or at least nearly identical, i.e. they are highly correlated, and the out-of-band components of the signals are independent, i.e. they are weakly correlated, or even uncorrelated. The reason for this effect is, that delta sigma modulators are always designed such, that the in-band signals after the modulator are highly correlated with the input signal corresponding to the so-called signal transfer function STF being 1. Hence, also the in-band signals of two delta sigma modulators that are fed by the same or nearly same input signals are highly correlated. On the other hand the delta sigma modulator devices have a strong non-linear characteristic, i.e. they map a continuous signal to a bit sequence, and have infinite memory due to the feedback loop. This means that even slight differences, e.g. in the coefficients, will cause very different bit sequences at the output of the delta sigma modulator device. As mentioned, the in-band signal components are highly correlated. Hence, the significant differences in the bit sequences must be caused by the out-of-band signal components.

The first modulated digital switching signal SD1 is amplified in the first parallel switching power amplifier SPA1 and then filtered in the first filter RFILT1 resulting in a first analogue output signal.

The second modulated digital switching signal SD2 is amplified in the second parallel switching power amplifier SPA2 and then filtered in the second filter RFILT2 resulting in a second analogue output signal.

The first and the second analogue output signal are combined in the signal combining device COMB, which results in a constructive superposition of the highly correlated in-band components of the output signals, and in an at least partially destructive superposition of the out-of-band components of the output signals. Thus, the amplified copy of the analogue input signal SA has a higher coding efficiency compared to an amplification performed by an amplifying device according to the state-of-the-art e.g. depicted in fig. 1.

The first and second filters RFILT1, RFILT2 preferably are reconstruction filters for generation of smooth analogue output signals.

In an alternative of the embodiment described above, instead of an analogue input signal SA, a sampled, digitized input signal is used, with each signal sample being represented by e.g. 14 bits.

In the embodiment depicted in fig. 5, the splitter SPL and the first and the second modulator MOD1, MOD2 together build the processing means PM as depicted in fig. 4.

In the embodiment depicted in fig. 5, only two parallel processing chains comprising a modulator MOD1, MOD2, a switching power amplifier SPA1, SPA2, and a filter RFILT1, RFILT2 are shown. However, in variations of the embodiment, also more than two parallel processing chains can be used.

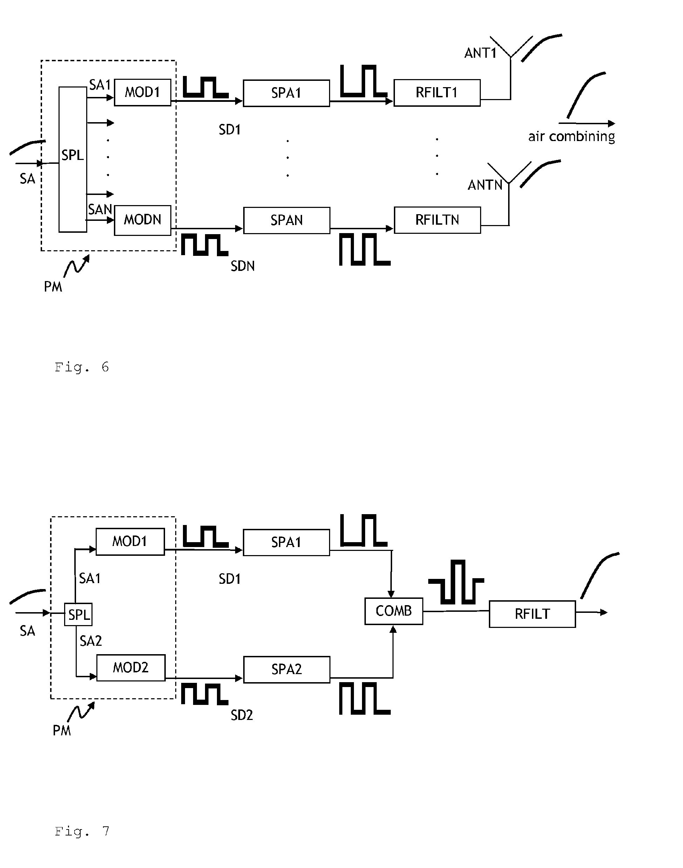

Fig. 6 schematically shows an amplifying device with a splitter SPL, N modulators MOD1-MODN, N parallel switching power amplifiers SPA1-SPAN, N filters RFILT1-RFILTN, and N antenna networks ANT1-ANTN for air combining of amplified and filtered output signals according to an embodiment of the invention.

The basic structure of the amplifying device is similar to the structure of the amplifying device depicted in fig. 5 and described above. Thus, in the following only the differences compared to the amplifying device depicted in fig. 5 are described.

Instead of only two chains of a modulator MOD1, MOD2, a switching power amplifier SPA1, SPA2 and a filter RFILT1, RFILT2, each chain being connected to an output of the splitter SPL, the embodiment depicted in fig. 6 comprises N chains with a modulator MOD1-MODN, a switching power amplifier SPA1-SPAN, a filter RFILT1-RFILTN, and an antenna network ANT1-ANTN, each chain being connected to one of N outputs of the splitter SPL.

In the splitter SPL, the analogue input signal SA is split in N identical or nearly identical analogue signals SA1-SAN which are sent to the input of the respective modulator MOD1-MODN.

Each of the N modulators has a different architecture, thus the in-band components of the modulated digital switching signals SD1-SDN are identical, or at least nearly identical, i.e. they are highly correlated, and the out-of-band components of the modulated digital switching signals SD1-SDN are independent, i.e. they are weakly correlated, correlated such that they interfere destructively, or even uncorrelated.

Furthermore, instead of a combining device COMB for combining amplified and filtered output signals as depicted in fig. 5, the embodiment depicted in fig. 6 comprises N antenna networks ANT1-ANTN for air combining of N amplified and filtered output signals.

In the embodiment depicted in fig. 6, the splitter SPL and the N modulators MOD1-MODN together build the processing means PM as depicted in fig. 4.

Fig. 7 schematically shows an amplifying device with a splitter SPL, a first and a second modulator MOD1, MOD2, a first and a second parallel switching power amplifier SPA1, SPA2, a signal combining device COMB for combining amplified output signals, and a filter RFILT for filtering the combined output signals according to an embodiment of the invention.

The basic structure of the amplifying device is similar to the structure of the amplifying device depicted in fig. 5 and described above. Thus, in the following only the differences compared to the amplifying device depicted in fig. 5 are described.

Instead of a dedicated filter RFILT1, RFILT2 being connected to the first and the second parallel switching power amplifier SPA1, SPA2 respectively, in the embodiment depicted in fig. 7, the first and the second parallel switching power amplifier SPA1, SPA2 are connected to the combining device COMB, which is in turn connected to the filter RFILT.

Thus, in the embodiment depicted in fig. 7, amplified digital output signals are combined in the combining device COMB and then filtered in the filter RFILT.

In the embodiment depicted in fig. 7, the splitter SPL and the first and the second modulator MOD1, MOD2 together build the processing means PM as depicted in fig. 4.

In the embodiment depicted in fig. 7, only two parallel processing chains comprising a modulator MOD1, MOD2 and a switching power amplifier SPA1, SPA2 are shown. However, in variations of the embodiment, also more than two parallel processing chains can be used.

According to another embodiment of the invention, the modulators e.g. used in the amplifying devices depicted in fig. 5, fig. 6, or fig. 7 are identical, but different sets of initial states for the shift registers of the different modulators are used. By means of choosing the appropriate different sets of initial states for the shift registers, the in-band components of the modulated signals are identical, or at least nearly identical, i.e. they are highly correlated, and the out-of-band components of the modulated signals are independent, i.e. they are weakly correlated, or even uncorrelated.

The appropriate different sets of initial states for the shift registers of the different modulators can be determined by means of simulating the power spectral density, and thus the coding efficiency for a multitude of different sets of initial states for the shift registers, and choosing the optimum different sets of initial states for the shift registers in terms of coding efficiency.

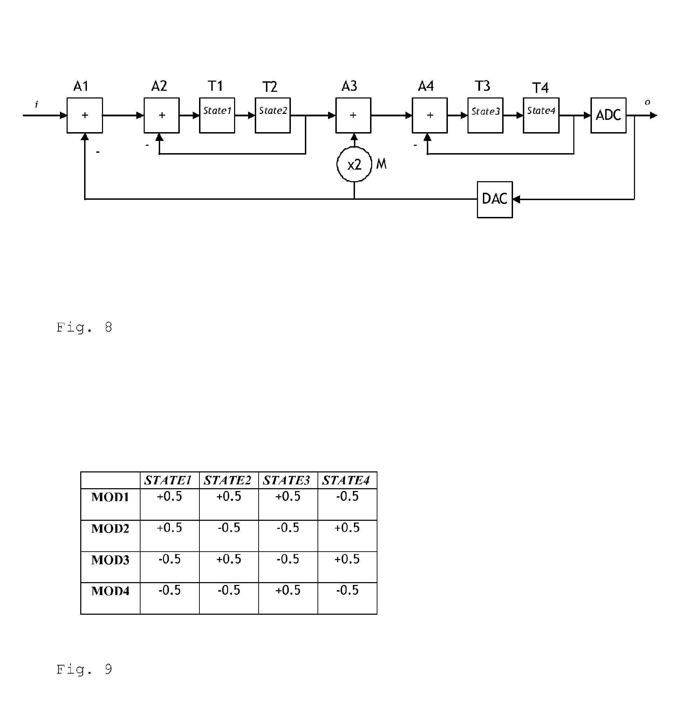

Fig. 8 schematically shows a structure of a bandpass delta sigma modulator with four shift registers that can be used in the embodiment of the invention.

The bandpass delta sigma modulator comprises 4 shift registers T1-T4, 4 adders A1-A4, a multiplier M, and analogue-to-digital converter ADC, and a digital-to-analogue converter DAC.

The bandpass delta sigma modulator converts the analogue signal i to a digital pattern o by means of the analogue-to digital-converter ADC. The generated output signal o is fed back and converted back to an analogue signal by the digital-to-analogue converter DAC. Subtracting the back converted feedback signal from the input signal i generates a signal that represents the error between the input signal I and the generated output signal o. The integrator structures and the factor 2 of the multiplier M correspond to a structure of a noise shaping filter that shapes the noise characteristics.

Fig. 9 shows four different sets of initial states STATE1-STATE4 for the shift registers of four bandpass delta sigma modulators MOD1-MOD4 which have been identified as appropriate by means of simulation according to an embodiment of the invention. The initial states STATE1-STATE4 are 2-level states, and can be either +0.5 or -0.5. However, generally, the shift registers can have an arbitrary number of levels with arbitrary values. Said four bandpass delta sigma modulators MOD1-MOD4 with said four different sets of initial states STATE1-STATE4 for the shift registers can e.g. be used in an amplifying device described above in fig. 5, fig. 6, or fig. 7.

It should be noted that any different sets of initial states for the shift registers of the identical delta sigma modulators will at least slightly improve the coding efficiency, so that already by means of choosing different sets of initial states, the coding efficiency can be at least slightly improved.

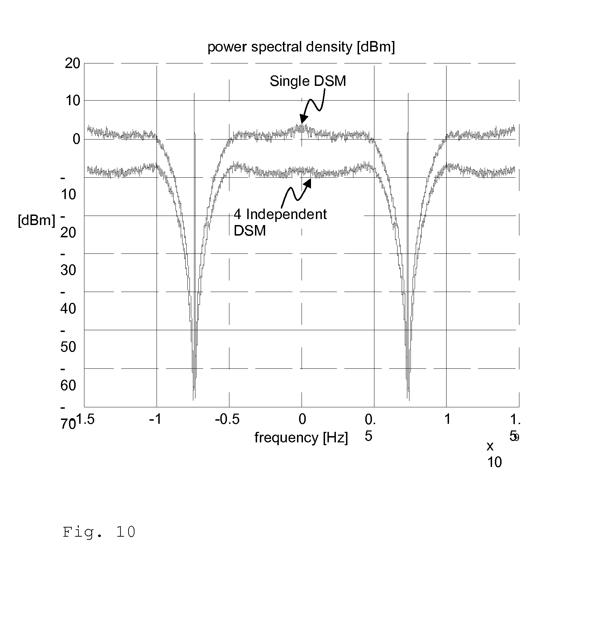

Fig. 10 schematically shows simulation results for the power spectral density of an amplifying device using the signal of a single delta sigma modulator, as e.g. depicted in fig. 1, compared to an amplifying device described above in fig. 5, fig. 6, or fig. 7 using signals of 4 parallel appropriately initialized delta sigma modulators with the four different sets of initial states STATE1-STATE4 for the shift registers depicted in the table in fig. 9, and 4 parallel switching power amplifiers.

The signal level of the combined signal of the 4 switching power amplifiers is normalized by the factor 0.25*0.25 in order to achieve the same in-band signal power in both cases.

In the case of 4 parallel, independent delta sigma modulators, the out-of-band signal power, i.e. the quantization noise, is significantly reduced compared to the case of a single delta sigma modulator. Thus, the coding efficiency is significantly increased compared to the case of a single delta sigma modulator.

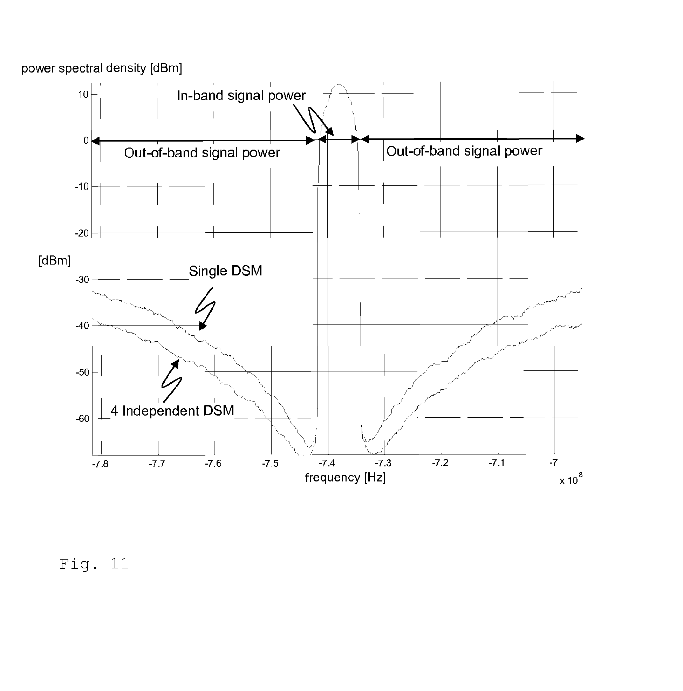

Fig. 11 schematically shows the zoomed representation of the simulation results depicted in fig. 10.

It can be seen, that the in-band signal power is the same for both cases, but the out-of-band signal power is significantly reduced in the case of 4 parallel, independent delta sigma modulators, compared to the case of a single delta sigma modulator.

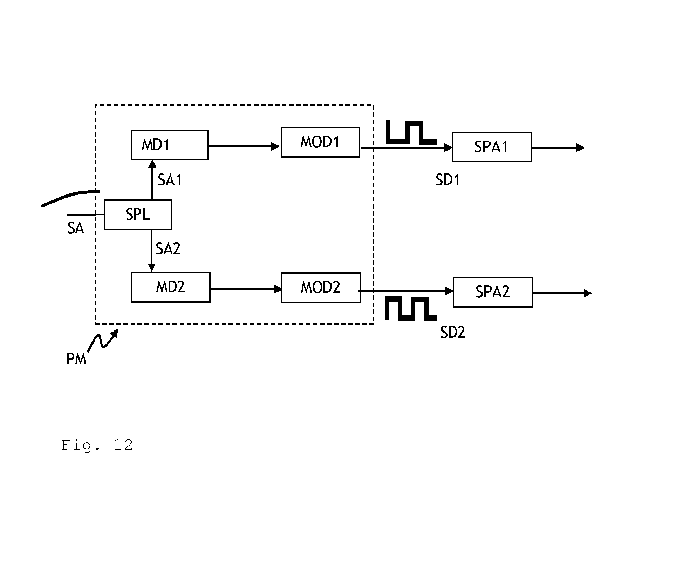

Fig. 12 schematically shows an amplifying device with a splitter SPL, a first and a second modifying device MD1, MD2, a first and a second modulator MOD1, MOD2, and a first and a second parallel switching power amplifier SPA1, SPA2 according to an embodiment of the invention.

The basic structure of the amplifying device is similar to the structure of the amplifying device depicted in fig. 5 and described above. Thus, in the following only the differences compared to the amplifying device depicted in fig. 5 are described.

The first output of the splitter SPL is connected to an input of the first modifying device MD1, and the second output of the splitter SPL is connected to an input of the second modifying device MD2. The first modifying device MD1 has an output which is connected to the input of the first modulator MOD1, and the second modifying device MD1 has an output which is connected to the input of the second modulator MOD2.

Instead of a different architecture for the first and the second modulator MOD1, MOD2, in the embodiment depicted in fig. 7, the first and the second modulator MOD1, MOD2 have the same architecture, and the two identical or nearly identical analogue signals SA1, SA2 are slightly differently modified by adding a noise level in the first and the second modifying device MD1, MD2 respectively, which results in highly correlated in-band signals and only weakly correlated or even uncorrelated out-of-band signals of the modulated input signals SD1, SD2. Thus, the coding efficiency is increased compared to amplifying devices according to the state-of-the-art, as e.g. depicted in fig. 1.

The noise level that is introduced by the signal modification in the first and the second modifying device MD1, MD2 individually for each parallel path shall have low power, such that it has no critical impact on the signal quality, and can partially be located outside the in-band region of the signal. Depending on the application and other requirements such as requirements resulting from standardisation bodies, a reasonable noise level can be e.g. 70dB to 80dB below the signal power. If certain applications require higher signal to noise ratio, the inserted noise may even be lower.

Amplified output signals at the output of the first switching power amplifier SPA1, and at the output of the second switching power amplifier SPA2 are filtered and combined by a combing device as depicted in fig. 5, or combined by air combining as depicted in fig. 6. Alternatively, the amplified output signals at the output of the first switching power amplifier SPA1, and at the output of the second switching power amplifier SPA2 are combined in a combining device, and then the combined output signals are filtered as depicted in fig. 7.

In the embodiment depicted in fig. 12, the splitter SPL, the first and the second modifying device MD1, MD2, and the first and the second modulator MOD1, MOD2 together build the processing means PM as depicted in fig. 4.

In the embodiments described above, the filters RFILT1-RFILTN preferably are reconstruction filters for generation of smooth analogue output signals.

In alternatives of the embodiments described above, instead of an analogue input signal SA, a sampled, digitized input signal is used, with each signal sample being represented by e.g. 14 bits.

In further alternatives of the embodiments described above, instead of having several parallel switching power amplifiers SPA1-SPAN, only one common switching power amplifier with several inputs for the modulated input signals SD1-SDN can be used. Furthermore, said common switching power amplifier may comprise the filters RFILT1-RFILTN and the signal combining device COMB.

The amplifying devices described in the embodiments above can be used in a base station for the transmission of signals from the base station to a user terminal in a communication network, however the invention is also applicable for transmission of signals from an arbitrary transmitting device to an arbitrary receiving device, as e.g. used in a point-to-point radio system or used for connection of devices within a rack.


## Claims

1. A method for amplification of a signal (SA) using a processing means (PM) with at least two modulators (MOD1-MODN), and using at least one switching power amplifier (SPA1-SPAN) , wherein

    ● the signal (SA) is processed in said processing means (PM) resulting in modulated input signals (SD1-SDN) for said at least one switching power amplifier (SPA1-SPAN) ,
    ● said modulated input signals (SD1-SDN) are generated in such a way, that they have a higher correlation for the in-band part of the spectrum than for the out-of-band part of the spectrum,
    ● said modulated input signals (SD1-SDN) are amplified in the at least one switching power amplifier (SPA1-SPAN) resulting in output signals,
    ● and said output signals are combined resulting in an amplified copy of the signal.

2. A method according to claim 1, wherein

    ● the signal (SA) is split in said processing means (PM) resulting in at least two identical signals (SA1-SAN) ,
    ● each of said at least two identical signals (SA1-SAN) is modulated in said processing means (PM) in a dedicated modulator (MOD1-MODN) resulting in said modulated input signals (SD1-SDN),
    ● and at least two different architectures are used for said dedicated modulators (MOD1-MODN) .

3. A method according to claim 1, wherein

    ● the signal (SA) is split in said processing means (PM) resulting in at least two identical signals (SA1-SAN) ,
    ● said at least two identical signals (SA1-SAN) are differently modified in said processing means (PM) resulting in at least two modified signals,
    ● and each of said at least two modified signals is modulated in said processing means (PM) in a dedicated modulator (MOD1-MODN) resulting in said modulated input signals (SD1-SDN).

4. A method according to claim 1, wherein said at least two identical signals (SA1-SAN) are differently modified by means of adding noise or pseudo-random signals.

5. A method according to claim 1, wherein

● the signal (SA) is split in said processing means (PM) resulting in at least two identical signals (SA1-SAN) ,
● each of said at least two identical signals (SA1-SAN) is modulated in said processing means (PM) in a dedicated modulator (MOD1-MODN) resulting in said modulated input signals (SD1-SDN),
● and at least two different sets of initial states for shift registers (STATE1-STATE4) are used for said dedicated modulators (MOD1-MODN) .

6. A method according to any of the preceding claims, wherein said modulators (MOD1-MODN) are pulse width modulators.

7. A method according to any of the preceding claims, wherein said modulators (MOD1-MODN) are delta sigma modulators.

8. A method according to any of the preceding claims, wherein said output signals are combined by means of air combining or in a signal combining device (COMB).

9. A method according to any of the preceding claims, wherein at least one filter (RFILT1-RFILTN) is used to generate analogue output signals before or after combination of said output signals.

10. An amplifying device for amplification of signals (SA), said amplifying device comprising at least one processing means (PM) and at least one switching power amplifier (SPA1-SPAN) , wherein

● said at least one processing means (PM) is adapted to process a signal (SA) resulting in modulated input signals (SD1-SDN) for said at least one switching power amplifier (SPA1-SPAN) ,
● said at least one processing means (PM) is adapted to generate said modulated input signals (SD1-SDN) in such a way, that they have a higher correlation for the in-band part of the spectrum than for the out-of-band part of the spectrum,
● and said at least one switching power amplifier (SPA1-SPAN) is adapted to amplify said modulated input signals (SD1-SDN) resulting in output signals.

11. An amplifying device according to claim 10, said amplifying device comprising a signal combining device (COMB) for combining said output signals resulting in an amplified copy of the signal.

12. A base station for mobile communication comprising an amplifying device according to claim 10 and at least one antenna network (ANT1-ANTN) for transmission of said amplified signals over an air interface.

Fig. 1

Clocking signal CS
=[1.3...4] x RF carrier

Supply
constant voltage source

Driver DR

Delta -Sigma
Modulator DSM

T2

D

G          S

1 bit

signal          ΣΔ          1 bit

Reconstruction    amplified
filter RFILT      signal

L       C

Noise-Shaping Filter NF

1 bit

T1

D

G          S

Fig. 2

input
(analogue)

G(z)          H(z)          E(z)

1 bit output (digital)
to switched output
stage

F1          SUM          F2          AD

+

−

DA

DSM

Fig. 3

Fig. 4

Fig. 5

ANT1

air combining

ANTN

Fig. 6

Fig. 7

Fig. 8

|  | STATE1 | STATE2 | STATE3 | STATE4 |
|---|---|---|---|---|
| MOD1 | +0.5 | +0.5 | +0.5 | -0.5 |
| MOD2 | +0.5 | -0.5 | -0.5 | +0.5 |
| MOD3 | -0.5 | +0.5 | -0.5 | +0.5 |
| MOD4 | -0.5 | -0.5 | +0.5 | -0.5 |

Fig. 9

Fig. 10

Fig. 11

Fig. 12

Europäisches
Patentamt

European
Patent Office

Office européen
des brevets

## EUROPEAN SEARCH REPORT

Application Number

EP 11 30 5362

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2009/123566 A1 (AGENCY SCIENCE TECH & RES [SG]; ZHOU YIJUN [SG]; CHIA YAN WAH MICHAEL) 8 October 2009 (2009-10-08)<br>* page 7, line 1 - page 8, line 14; figure 4a *<br>* page 13, line 9 - page 14, line 21; figure 4b *<br>----- | 1-12 | INV.<br>H03F3/217<br>H03F3/193<br>H03F3/21<br>H03F3/24<br>H03M3/00<br>H04L27/12<br>H04B1/04<br>H04L25/49<br>H04L27/36 |
| X | JAU-HORNG CHEN ET AL: "A Polar-Transmitter Architecture Using Multiphase Pulsewidth Modulation", IEEE TRANSACTIONS ON CIRCUITS AND SYSTEMS I: REGULAR PAPERS, IEEE, US, vol. 58, no. 2, 1 February 2011 (2011-02-01), pages 244-252, XP011328809, ISSN: 1549-8328, DOI: 10.1109/TCSI.2010.2071918<br>* page 245, left-hand column, line 22 - page 249, right-hand column, line 14; figures 3,12 *<br>----- | 1-3,6,8, 10-12 | |
| X | WOLFGANG HEINRICH ET AL: "Advanced switch-mode concepts using GaN: The class-S amplifier", MICROWAVE RADAR AND WIRELESS COMMUNICATIONS (MIKON), 2010 18TH INTERNATIONAL CONFERENCE ON, IEEE, PISCATAWAY, NJ, USA, 14 June 2010 (2010-06-14), pages 1-6, XP031726142, ISBN: 978-1-4244-5288-0<br>* page 1, left-hand column, line 12 - page 6, left-hand column, line 18; figures 1,2,11 *<br>-----<br>-/-- | 1-3,7-12 | TECHNICAL FIELDS SEARCHED (IPC)<br>H03F<br>H03M<br>H04L<br>H04B<br>H03K |

The present search report has been drawn up for all claims

| Place of search | Date of completion of the search | Examiner |
|---|---|---|
| The Hague | 27 September 2011 | Fedi, Giulio |

EPO FORM 1503 03.82 (P04C01)

**Europäisches Patentamt**
**European Patent Office**
**Office européen des brevets**

## EUROPEAN SEARCH REPORT

Application Number

EP 11 30 5362

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 4 968 987 A (NAKA HIDEYUKI [JP] ET AL) 6 November 1990 (1990-11-06) * column 2, line 52 - column 3, line 43; figure 2 * ----- | 2-5 | |
| A | US 7 443 324 B1 (MUHAMMAD KHURRAM [US]) 28 October 2008 (2008-10-28) * column 8, line 20 - column 9, line 18; figure 6 * ----- | 2-5 | |

TECHNICAL FIELDS SEARCHED (IPC)

The present search report has been drawn up for all claims

| Place of search | Date of completion of the search | Examiner |
|---|---|---|
| The Hague | 27 September 2011 | Fedi, Giulio |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 11 30 5362

This annex lists the patent family members relating to the patent documents cited in the above-mentioned European search report.
The members are as contained in the European Patent Office EDP file on
The European Patent Office is in no way liable for these particulars which are merely given for the purpose of information.

27-09-2011

| Patent document cited in search report | Publication date | Patent family member(s) | Publication date |
|---|---|---|---|
| WO 2009123566 A1 | 08-10-2009 | CN 102165689 A<br>US 2011102079 A1 | 24-08-2011<br>05-05-2011 |
| US 4968987 A | 06-11-1990 | JP 1288016 A<br>JP 2647136 B2 | 20-11-1989<br>27-08-1997 |
| US 7443324 B1 | 28-10-2008 | NONE | |

EPO FORM P0459

For more details about this annex : see Official Journal of the European Patent Office, No. 12/82